Europäisches Patentamt

European Patent Office

Office européen des brevets

(19)

(11) **EP 0 430 365 B1**

(12) **FASCICULE DE BREVET EUROPEEN**

(45) Date de publication et mention
de la délivrance du brevet:
**03.04.1996 Bulletin 1996/14**

(51) Int Cl.6: **H03K 3/023**, H03K 5/13

(21) Numéro de dépôt: **90203104.6**

(22) Date de dépôt: **23.11.1990**

(54) **Circuit retardateur à retard réglable**

Verzögerungsschaltung mit einstellbarer Verzögerung

Delay circuit with adjustable delay

(84) Etats contractants désignés:
**DE FR GB IT NL**

(30) Priorité: **28.11.1989 FR 8915624**

(43) Date de publication de la demande:
**05.06.1991 Bulletin 1991/23**

(73) Titulaires:
• **PHILIPS COMPOSANTS**
**F-92150 Suresnes (FR)**
Etats contractants désignés:
**FR**
• **Philips Electronics N.V.**
**NL-5621 BA Eindhoven (NL)**
Etats contractants désignés:
**DE GB IT NL**

(72) Inventeurs:
• **Barbu, Stéphane, Société Civile S.P.I.D.**
**F-75008 Paris (FR)**
• **Le Pailleur, Laurent, Société Civile S.P.I.D.**
**F-75008 Paris (FR)**

(74) Mandataire: **Charpail, François et al**
**Société Civile S.P.I.D.**
**156, Boulevard Haussmann**
**F-75008 Paris (FR)**

(56) Documents cités:
**EP-A- 0 100 177**          **US-A- 4 862 020**

**Description**

La présente invention a pour objet un circuit retardateur à retard réglable mettant en oeuvre une bascule de commutation.

Selon l'art antérieur, un tel circuit met en oeuvre une bascule de type D associée à une horloge. Le retard est déterminé par un produit résistance-capacité RC, ce qui rend difficile l'obtention d'un retard variable dans un circuit intégré.

Les brevets US-4 795 923 et US-4 862 020 décrivent des circuits retardateurs intégrables dont le retard est réglable de manière continue à l'aide d'une tension variable. Ces circuits nécessitent plusieurs étages différentiels dont les sorties sont couplées, d'où des schémas relativement compliqués. La présente invention a pour objet un circuit du type mentionné en premier lieu et dont le retard est réglable de manière continue, tout en étant simple à mettre en oeuvre.

Le circuit selon l'invention est ainsi caractérisé par la revendication 1. Les première et deuxième résistances peuvent avoir la même valeur. La première et la deuxième source de courant peuvent avoir la même valeur de courant.

La première et la deuxième tension de commande ont avantageusement pour valeur respectivement $V_0 + \Delta V$ et $V_0 - \Delta V$, $\Delta V$ étant une variable dont la valeur absolue est inférieure à celle de la constante $V_0$.

L'invention sera mieux comprise à la lecture de la description qui va suivre donnée à titre d'exemple non limitatif en liaison avec les dessins qui représentent :

- la figure 1, un circuit selon l'invention,
- la figure 2, une illustration de la fonction de retard recherchée,
- et les figures 3a, 3b et 4 un mode de réalisation préféré de l'invention.

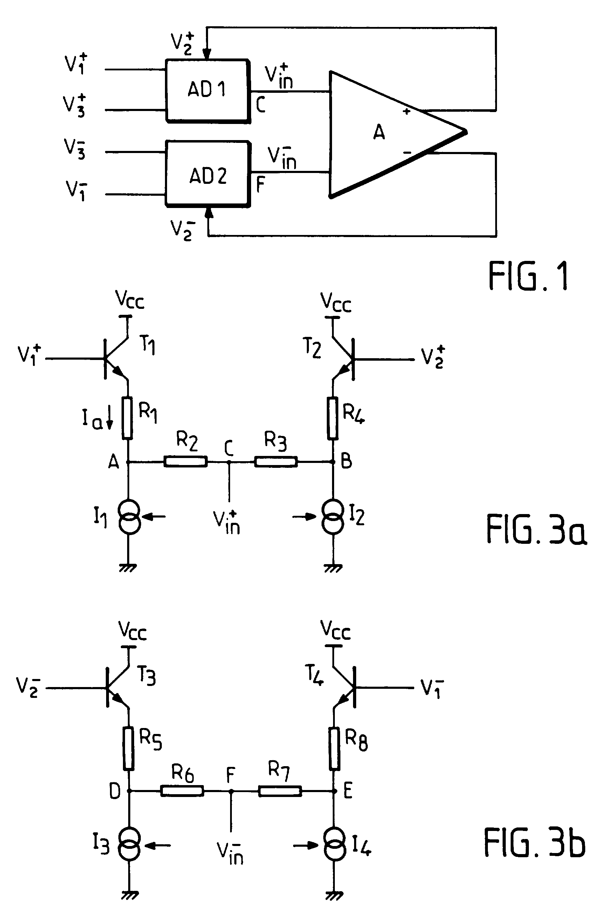

Selon la figure 1, un amplificateur différentiel A présente deux entrées et deux sorties délivrant des signaux respectivement $V_2^-$ et $V_2^+$. Ces deux sorties sont bouclées en réaction sur les entrées correspondantes à travers deux additionneurs à plusieurs entrées respectivement AD1 et AD2. Ce bouclage en réaction réalise ainsi une bascule de commutation.

Outre l'entrée de réaction recevant le signal $V_2^+$, l'additionneur AD1 présente une entrée de signal recevant un signal $V_1^+$ et une entrée de commande recevant un niveau de tension continue $V_3^+$ que l'on peut faire varier.

Outre l'entrée de réaction recevant le signal $V_2^-$, l'additionneur AD2 présente une entrée de signal recevant un signal $V_1^-$ et une entrée de commande recevant un niveau de tension continu $V_3^-$ que l'on peut faire varier.

Les signaux $V_1^+$ et $V_1^-$ sont représentatifs des deux polarités du signal d'entrée à retarder. Les signaux $V_3^+$ et $V_3^-$ sont mis en oeuvre pour obtenir le fonctionnement décalé de la bascule de commutation et leur valeur influe sur la valeur du retard $\Delta t$. La figure 2 illustre la valeur de retard $\Delta t$ pour les signaux carrés.

On peut poser par exemple :

$$V_3^+ = V_0 + \Delta V$$

$$V_3^- = V_0 - \Delta V$$

$V_0$ = tension constante.
$\Delta V$ = tension variable (positive, négative ou nulle) de valeur absolue inférieure à celle de $V_0$.

Les signaux de commande peuvent être directement des tensions de commandes injectées aux troisièmes entrées d'additionneurs de tension.

Les figures 3a et 3b représentent un mode de réalisation préféré des additionneurs AD1 et AD2, pour lesquels les tensions $V_3^+$ et $V_3^-$ interviennent par l'intermédiaire de sources de courant. Les signaux de commande sont alors par exemple des tensions commandant l'intensité des sources de courant.

Selon la figure 3a, l'additionneur AD1 comporte deux transistors npn $T_1$ et $T_2$ dont le collecteur est connecté à une source de tension d'alimentation $V_{cc}$, dont la base reçoit les signaux respectivement $V_1^+$ et $V_2^+$ et dont l'émetteur est connecté à une branche comportant en série, pour le transistor $T_1$ une résistance $R_1$ et une source de courant variable $I_1$, et pour le transistor $T_2$ une résistance $R_4$ en série avec une source de courant variable $I_2$.

Entre le point commun A à la résistance $R_1$ et à la source de courant variable $I_1$ et le point commun B à la résistance $R_4$ et à la source de courant variable $I_2$, sont disposées deux résistances en série $R_2$ et $R_3$ dont le point commun C, qui délivre le signal $V_{in}^+$ est connecté à une entrée de l'amplificateur A.

Le courant des sources de courant $I_1$ et $I_2$ peut être commandé par une tension, de préférence la même tension. Ceci permet une réalisation sous forme de circuit intégré.

Selon la figure 3b, l'additionneur AD2 comporte deux transistors npn $T_3$ et $T_4$ dont le collecteur est connecté à la source de tension d'alimentation $V_{cc}$, dont la base reçoit les signaux respectivement $V_2^-$ et $V_1^-$ et dont l'émetteur est connecté à une branche comportant en série, pour le transistor $T_3$ une résistance $R_5$ et une source de courant variable $I_3$, et pour le transistor $T_4$ une résistance $R_8$ et une source de courant variable $I_4$.

Entre le point commun D à la résistance $R_5$ et à la source de courant variable $I_3$ et le point commun E à la résistance $R_8$ et à la source de courant variable $I_4$, dont disposées deux résistances en série $R_6$ et $R_7$ dont le point commun F, qui délivre le signal $V_{in}^-$ est connecté à l'autre entrée de l'amplificateur A. Le courant des sources de courant $I_3$ et $I_4$ peut être commandé par une même tension.

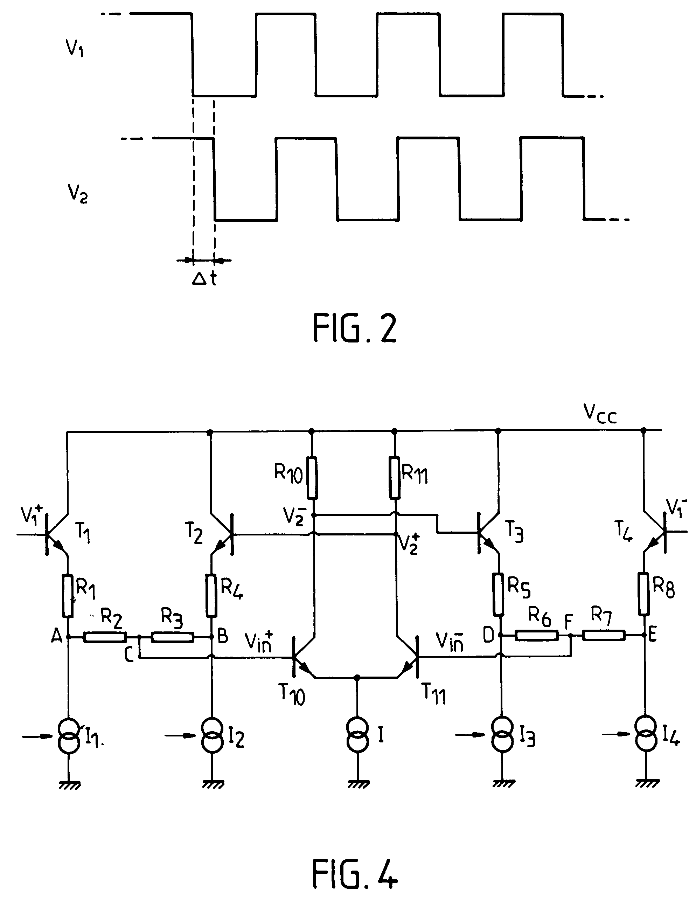

La figure 4 montre un mode de réalisation préféré dans lequel les additionneurs AD1 et AD2 sont l'un et l'autre conformes aux modes des figures 3a et 3b (avec les mêmes signes de référence) et dans lequel l'amplificateur A est constitué par un étage différentiel à deux transistors $T_{10}$ et $T_{11}$ dont les émetteurs couplés sont connectée à une source de courant I. Les collecteurs des transistors $T_{10}$ et $T_{11}$ sont reliés à la source de tension d'alimentation $V_{cc}$ à travers des résistances respectivement $R_{10}$ et $R_{11}$ et leurs bases sont connectées respectivement aux points C et F. Le collecteur du transistor $T_{10}$ qui délivre le signal de sortie $V_2^-$ est connecté à la base du transistor $T_3$ et le collecteur du transistor $T_{11}$, qui délivre le signal de sortie $V_2^+$ est connecté à la base du transistor $T_2$.

L'idée de base de l'invention consiste à faire varier le point de repos des entrées de l'amplificateur différentiel pour faire varier le retard $\Delta t$. En d'autres termes, les points C et F sont portés à des potentiels continus que l'on peut faire varier, et le retard dépend, ainsi qu'on va maintenant le montrer, de l'écart entre ces potentiels.

Soit $I_a$ (Fig3a) le courant traversant la résistance $R_1$.

Soit $V_{BE1}$ la tension base-émetteur du transistor $T_1$, et $V_{BE2}$ celle du transistor $T_2$. On a, en négligeant les résistances de base et les courants de base.

$$V_1^+ - V_{BE1} - R_1 I_a - (I_a - I_1)(R_2 + R_3) = V_2^+ - V_{BE2} - R_4(I_1 + I_2 - I_a)$$

et

$$V_{BE1} - V_{BE2} = V_T \mathrm{Log} \frac{I_a}{I_1 + I_2 - I_a} \qquad V_T = 26mV.$$

d'où

$$V_{BE1} \simeq V_{BE2} \text{ si } I_a \simeq \frac{I_1 + I_2}{2}$$

cette condition sera explicitée plus loin.
On choisit par hypothèse :

$$R_1 = R_4 \qquad R_2 = R_3 \qquad I_1 = I_2 = I_0 + \Delta I$$

On a alors :

$$I_a = \frac{V_1^+ - V_2^+ + 2I_1(R_1 + R_2)}{2(R_1 + R_2)} = \frac{V_1^+ - V_2^+}{2(R_1 + R_2)} + I_1$$

$$V_{in}^+ = V_1^+ - R_1 I_a - R_2(Ia - I_1) - V_{BE1}$$

$$V_{in}^+ = \qquad\qquad\qquad (1)$$

ceci correspond à une valeur de $V_3^+$

$$V_3^+ = 2R_1(I_0 + \Delta I)$$

(l'additionneur AD1 a un gain de 0,5)

$$V_{BE1} \simeq V_{BE2} \text{ si } I_a \simeq I_1 \text{ soit } \left(V_1^+ - V_2^+\right) \ll 2(R_1 + R_2)I_1$$

De la même façon, on obtient pour le schéma de la figure 3b et avec les hypothèses $R_5 = R_8$ et $R_6 = R_7$    $I_3 = I_4 = I_0 - \Delta I$

$$V_{in}^- = \frac{V_1^- + V_2^-}{2} - R_5(I_0 - \Delta I) - V_{BE4} \tag{2}$$

d'où

$$V_3^- = -2R_5(I_0 - \Delta I). \text{ (additionneur de gain 0,5).}$$

$$V_{BE3} \simeq V_{BE4} \text{ si } \left(V_1^- - V_2^-\right) \ll 2(R_5 + R_6)I_3$$

$V_{BE3}$ et $V_{BE4}$ désignant les tensions base-émetteur des transistors $T_3$ et $T_4$.

Les équations (1) et (2) donnent alors (en choisissant $R_1 = R_5$)

$$\Delta V_{in} = V_{in}^+ - V_{in}^- = \frac{V_1^+ - V_1^-}{2} + \frac{V_2^+ - V_2^-}{2} = 2R_1\Delta I + (V_{BE4} - V_{BE1}) \tag{3}$$

$\Delta V_{in}$ représente le décalage du point de fonctionnement de la bascule de commutation. Il varie linéairement en fonction de $\Delta I$.

On a, suivant les équations régissant les étages différentiel :

$$V_2^+ - V_2^- = \frac{R_{10}I}{2} \text{ th}\left(\frac{V_{in}^+ - V_{in}^-}{2V_T}\right)$$

avec $R_{10} = R_{11}$, th = fonction tangente hyperbolique.

A l'équilibre de l'étage différentiel ($V_{in}^+ = V_{in}^-$), $V_1^+$ n'est pas égal à $V_1^-$

En effet, on a alors :

$$V_1^+ - V_1^- = 4R_1\Delta I + 2V_T \text{Log} \frac{I_0 + \Delta I}{I_0 - \Delta I}$$

L'écart entre $V_1^+$ et $V_1^-$ à l'équilibre de l'étage différentiel dépend uniquement de $\Delta I$, c'est-à-dire de l'écart entre les courants dans les additionneurs des figures 3a et 3b.

La formule donnant le temps de réponse à 50% dénommé $t_{50}$ de l'amplitude est la suivante :

$$t_{50} = \frac{4V_T}{R_{10}I} \tau \text{ Log}(2 + \frac{R_{10}I}{4V_T} + \frac{R_{10}I}{V_T} \frac{\Delta I}{\Delta V_1})$$

$t_{50}$ peut être pris comme valeur caractéristique du retard. avec $\Delta V_1$ = amplitude crête-crête du signal à retarder. et $\tau$ = temps de réponse intrinsèque de l'étage différentiel.

$$\tau = \frac{R_{10}(R_1 + R_2) \ C}{R_{10} + R_1 + R_2}$$

C = capacité de l'étage différentiel dans son schéma équivalent.

(une capacité C pour chacun des collecteurs de $T_{10}$ et $T_{11}$).

Les calculs ci-dessus ont été effectués avec certaines hypothèses ($R_1 = R_4 = R_5 = R_8$, $R_2 = R_3$ et $R_6 = R_7$), mais il ne s'agit pas là bien entendu de conditions nécessaires. En particulier, les rapports entre $R_1$ et $R_4$, $R_5$ et $R_8$ d'une part, et entre $R_2$ et $R_3$ et $R_6$ et $R_7$ d'autre part influent sur la symétrie de la forme d'onde, c'est-à-dire permettent d'obtenir un temps de montée égal ou différent du temps de descente. Si AD1 et AD2 sont différents, on peut en effet obtenir des temps de réponse différents sur chaque entrée.

Pour $R_2 < R_3$ on obtient une avance de phase pour l'entrée correspondante et un retard de phase pour $R_2 > R_3$.

Pour $R_1 < R_4$, on obtient une avance de phase pour l'entrée correspondante et un retard de phase pour $R_1 > R_4$.

Des raisonnements similaires s'apliquent aux rapports entre $R_5$ et $R_8$ d'une part, et $R_6$ et $R_7$ d'autre part.

En effet, les valeurs desdites résistances influent sur la valeur de l'écart entre $V_{1n}^+$ et $V_{1n}^-$ d'une part et sur la valeur de $\tau$ d'autre part.

Dans l'hypothèse où les deux cellules AD1 et AD2 sont structurellement identiques, on a en effet :

$$\Delta V_{in} = V_{in}^+ - V_{in}^- = \frac{R_3 + R_4}{R_1 + R_2 + R_3 + R_4}\left[\left(V_1^+ - V_1^-\right) - R_1\,(I_1 - I_3)\right.$$

$$\left. - (V_{BE1} - V_{BE2})\right] + \frac{R_1 + R_2}{R_1 + R_2 + R_3 + R_4}\left[\left(V_2^+ - V_2^-\right) - R_4\,(I_2 - I_4) - (V_{BE3} - V_{BE4})\right]$$

et $I_1 - I_3 = I_2 - I_4 = 2\Delta I$.

En inversant la formule citée plus haut et donnant $V_2^+ - V_2^-$ en fonction de $V_{in}^+ - V_{in}^-$, on a :

$$V_{in}^+ - V_{in}^- = 2V_T\ \text{arc th}\ \frac{2\left(V_2^+ - V_2^-\right)}{R_{10}I}$$

arc th = fonction arc tangente hyperbolique.

d'où :

$$V_1^+ - V_1^- = \frac{2\,(R_1 + R_2 + R_3 + R_4)}{R_3 + R_4}\ V_T\ \text{arc th}\ \frac{2\left(V_2^+ - V_2^-\right)}{R_{10}I}$$

$$-\frac{R_1 + R_2}{R_3 + R_4}\left[\left(V_2^+ - V_2^-\right) - R_4\,(I_2 - I_4) - (V_{BE3} - V_{BE4})\right]$$

$$+\frac{R_1}{R_3 + R_4}\left[\,(I_1 - I_3) + (V_{BE1} - V_{BE2})\,\right]$$

La condition d'hystérésis s'écrit :

$$\frac{d\left(V_1^+ - V_1^-\right)}{d\left(V_2^+ - V_2^-\right)} = 0$$

soit

$$(V_2^+ - V_2^-)_{hyst} = \frac{R_{10}I}{2}\sqrt{1 - \frac{2V_T}{R_{10}I}\left(1 + \frac{R_3 + R_4}{R_1 + R_2}\right)}$$

d'où la condition de fonctionnement

$$1 + \frac{R_3 + R_4}{R_1 + R_2} < \frac{R_{10}I}{2V_T}$$

## Revendications

1. Circuit retardateur à retard réglable mettant en oeuvre une bascule de commutation comportant un amplificateur différentiel ($T_{10}$, $T_{11}$) présentant une première sortie bouclée en réaction sur une première entrée à travers un premier additionneur (AD1), et une deuxième sortie bouclée en réaction sur une deuxième entrée à travers un deuxième additionneur (AD2), l'ensemble constituant ladite bascule de commutation, chacun desdits additionneurs inclut un premier transistor ($T_1$ ; $T_4$) dont la base est connectée à une borne d'entrée de signal à retarder ($V_1^+$ ; $V_1^-$) et un deuxième transistor ($T_2$ ; $T_3$) dont la base est connectée à la sortie correspondante de l'amplificateur différentiel, le trajet de courant principal du premier transistor étant disposé en série successivement avec une première résistance ($R_1$ ; $R_8$) et une première source de courant ($I_1$ ; $I_4$) et celui du deuxième transistor, disposé en série successivement avec une deuxième résistance ($R_4$ ; $R_5$) et une deuxième source de courant ($I_2$ ; $I_3$), chacun desdits additionneurs inclut en outre un pont de résistances formé d'une troisième résistance ($R_2$ ; $R_7$) en série avec une quatrième résistance ($R_3$ ; $R_6$) qui relie le point commun (A ; E) entre la première source de courant ($I_1$ ; $I_4$) et la première résistance ($R_1$ ; $R_8$) au point commun (B ; D) entre la deuxième source de courant ($I_2$ ; $I_3$) et la deuxième résistance ($R_4$ ; $R_5$), le point intermédiaire (C ; F) de ce pont de résistances formant une sortie de l'additionneur connectée à l'entrée correspondante de l'amplificateur, circuit dans lequel les première et deuxième sources de courant sont commandées, pour le premier additionneur, par une première tension de commande ($V^+_3$), et pour le deuxième additionneur, par une deuxième tension de commande ($V^-_3$).

2. Circuit selon la revendication 1, caractérisé en ce que les première et deuxième résistances ($R_1$, $R_4$ ; $R_8$, $R_5$) ont la même valeur et en ce que la première et deuxième sources de courant d'un même additionneur ($I_1$, $I_2$ ; $I_3$, $I_4$) ont la même valeur de courant.

3. Circuit selon une des revendication 1 ou 2 caractérisé en ce que les troisième et quatrième résistances ($R_2$, $R_3$ ; $R_7$, $R_6$) ont la même valeur.

4. Circuit selon une des revendications 1 à 3, caractérisé en ce que les première et deuxième tensions de commande ($V^+_3$, $V^-_3$) ont pour valeur respectivement $V_o + \Delta V$ et $V_o - \Delta V$, $\Delta V$ étant une variable dont la valeur absolue est inférieure à $V_o$.

## Patentansprüche

1. Verzögerungsschaltung mit einstellbarer Verzögerung zur Betätigung eines Schaltflipflops mit einem Differenzverstärker ($T_{10}$, $T_{11}$) mit einem ersten rückkopplungsgeschleiften Ausgang nach einem ersten Eingang über einen ersten Addierer (AD1) und mit einem zweiten rückkopplungsgeschleiften Ausgang nach einem zweiten Eingang über einen zweiten Addierer (AD2), wobei diese Einheit das Schaltflipflop darstellt, jeder dieser Addierer einen ersten Transistor ($T_1$, $T_4$) enthält, dessen Basis mit einer Eingangsklemme für ein zu verzögerndes Signal ($V^+_1$, $V^-_1$) verbunden ist, und einen zweiten Transistor ($T_2$, $T_3$) enthält dessen Basis mit dem entsprechenden Ausgang des Differenzverstärkers verbunden ist, der Weg des Hauptstroms des ersten Transistors aufeinanderfolgend in Reihe mit einem ersten Widerstand ($R_1$, $R_8$) und mit einer ersten Stromquelle ($I_1$, $I_4$) und der des zweiten Transistors aufeinanderfolgend in Reihe mit einem zweiten Widerstand ($R_4$, $R_5$) und mit einer zweiten Stromquelle ($I_2$, $I_3$) geschaltet sind, jeder der Addierer außerdem eine Widerstandsbrücke aus einem dritten Widerstand ($R_2$, $R_7$) in Reihe mit einem vierten Widerstand ($R_3$, $R_6$) geschaltet ist, der den gemeinsamen Punkt (A, E) zwischen der ersten Stromquelle ($I_1$, $I_4$) und dem ersten Widerstand ($R_1$, $R_8$) mit dem gemeinsamen Punkt (B, D) zwischen der zweiten Stromquelle ($I_2$, $I_3$) und dem zweiten Widerstand ($R_4$, $R_5$) verbindet, der Zwischenpunkt (C, F) dieser Widerstandsbrücke einen Ausgang des Addierers bildet, der mit dem entsprechenden Eingang des Verstärkers verbunden ist, und in dieser Schaltung erste und zweite Stromquellen für den ersten Addierer durch eine erste Steuerspannung ($V^+_3$) und für den zweiten Addierer durch eine zweite Steuerspannung ($V^-_3$) gesteuert werden.

2. Schaltung nach Anspruch 1, <u>dadurch gekennzeichnet</u>, daß der erste und der zweite Widerstand ($R_1$, $R_4$; $R_8$, $R_5$) denselben Wert haben, un daß die erste und die zweite Stromquelle eines selben Addierers ($I_1$, $I_2$; $I_3$, $I_4$) denselben Stromwert haben.

3. Schaltung nach einem der Ansprüche 1 oder 2, <u>dadurch gekennzeichnet</u>, daß der dritte und der vierte Widerstand ($R_2$, $R_3$; $R_7$, $R_6$) denselben Wert haben.

4. Schaltung nach einem der Ansprüche 1 bis 3, <u>dadurch gekennzeichnet</u>, daß die erste und die zweite Steuerspannung ($V^+_3$, $V^-_3$) einen Wert $V_0 + \Delta V$ bzw. $V_0 - \Delta V$ haben, wobei $\Delta V$ eine Variable ist, deren Absolutwert niedriger als $V_0$ ist.

## Claims

1. A delay circuit with an adjustable delay, employing a switching flip-flop, comprising a differential amplifier ($T_{10}$, $T_{11}$) having a first output fed back to a first input *via* a first adder (AD1) and having a second output fed back to a second input *via* a second adder (AD2), together forming said switching flip-flop, which adders each include a first transistor ($T_1$; $T_4$) whose base is connected respectively to an input terminal ($V^+_1$; $V^-_1$) for the signal to be delayed and a second transistor ($T_2$; $T_3$) whose base is connected to the corresponding output of the differential amplifier, the main current path of the first transistor being arranged in series with successively a first resistor ($R_1$; $R_8$) and a first current source ($I_1$; $I_4$) and that of the second transistor being arranged in series with successively a second resistor ($R_4$; $R_5$) and a second current source ($I_2$; $I_3$), each of said adders moreover including a resistor bridge formed by a third resistor

($R_2$; $R_7$) in series with a fourth resistor ($R_3$; $R_6$), which connects the point (A; E) common to the first current source ($I_1$; $I_4$) and the first resistor ($R_1$ ; $R_8$) to the point (B; D) common to the second current source ($I_2$; $I_3$) and the second resistor ($R_4$; $R_5$), the intermediate point (C; F) of this resistor bridge forming an output of the adder, which output is connected to the corresponding input of the amplifier, in which circuit the first and the second current sources are controlled by a first control voltage ($V_3^+$) for the first adder and by a second control voltage ($V_3^-$) for the second adder.

2.  A circuit as claimed in Claim 1, characterised in that the first and second resistors ($R_1$, $R_4$; $R_8$, $R_5$) have the same value and in that the first and the second current source of the same adder ($I_1$, $I_2$ ; $I_3$, $I_4$) have the same current value.

3.  A circuit as claimed in Claim 1 or 2, characterised in that the third and the fourth resistor ($R_2$, $R_3$; $R_7$, $R_8$) have the same value.

4.  A circuit as claimed in any one of the Claims 1 to 3, characterised in that the first and second control voltage ($V_3^+$ $V_3^-$) have the values $V_0 + \Delta V$ and $V_0 - \Delta V$, respectively, $\Delta V$ being a variable whose absolute value is smaller than $V_0$.

FIG. 1

FIG. 3a

FIG. 3b

FIG. 2

FIG. 4